# FASCICULE DE BREVET EUROPEEN

(11) **EP 2 696 993 B1**
(45) Date de publication et mention de la délivrance du brevet: **20.03.2019**
(21) Numéro de dépôt: 12724664.3
(22) Date de dépôt: 13.04.2012
(51) Int. Cl.: B05D 7/24, B05D 3/02, C08F 212/08, C09D 133/12, G03F 7/00

(54) **PROCÉDÉ DE PRÉPARATION DE SURFACES**
VERFAHREN ZUR VORBEREITUNG VON OBERFLÄCHEN
METHOD FOR THE PREPARING SURFACES

(30) Priorité: 15.04.2011 FR 1153302; 22.04.2011 US 201161478116 P
(43) Date de publication de la demande: 19.02.2014
(73) Titulaire: Arkema France, 92700 Colombes (FR); Commissariat à l'Énergie Atomique et aux Énergies Alternatives, 75015 Paris (FR); Institut Polytechnique de Bordeaux, 33402 Talence Cedex (FR)
(72) Inventeur: NAVARRO, Christophe, F-64100 Bayonne (FR); MAGNET, Stéphanie, F-64370 Morlanne (FR); CHEVALIER, Xavier, F-38100 Grenoble (FR); TIRON, Raluca, F-38950 Saint-martin-le-vinoux (FR)
(74) Mandataire: Schaefer, Anne-Sophie
(86) Numéro de dépôt international: PCT/FR2012/050819
(87) Numéro de publication internationale: WO 2012/140383

(56) Documents cités:
- MARY E. THOMSON ET AL: "High Solids Nitroxide-Mediated Microemulsion Polymerization of MMA with a Small Amount of Styrene and Synthesis of (MMA- co -St)- block -(BMA- co -St) Polymers", MACROMOLECULES, 10 février 2011 (2011-02-10), XP055017538, ISSN: 0024-9297, DOI: 10.1021/ma1026302
- TURCHANIN A ET AL: "High thermal stability of cross-linked aromatic self-assembled monolayers: Nanopatterning via selective thermal desorption", 29 janvier 2007 (2007-01-29), APPLIED PHYSICS LETTERS, AIP, AMERICAN INSTITUTE OF PHYSICS, MELVILLE, NY, US, PAGE(S) 53102 - 053102, XP012095852, ISSN: 0003-6951 le document en entier
- BENOÎT LESSARD ET AL: "Incorporating glycidyl methacrylate into block copolymers using poly(methacrylate- ran -styrene) macroinitiators synthesized by nitroxide-mediated polymerization", JOURNAL OF POLYMER SCIENCE PART A: POLYMER CHEMISTRY, vol. 47, no. 10, 15 mai 2009 (2009-05-15), pages 2574-2588, XP055017544, ISSN: 0887-624X, DOI: 10.1002/pola.23343
- P. MANSKY: "Controlling Polymer-Surface Interactions with Random Copolymer Brushes", SCIENCE, vol. 275, no. 5305, 7 mars 1997 (1997-03-07), pages 1458-1460, XP055017500, ISSN: 0036-8075, DOI: 10.1126/science.275.5305.1458 cité dans la demande
- NICOLAS J ET AL: "LIVING CHARACTER OF POLYMER CHAINS PREPARED VIA NITROXIDE-MEDIATED CONTROLLED FREE-RADICAL POLYMERIZATION OF METHYL METHACRYLATE IN THE PRESENCE OF A SMALL AMOUNT OF STYRENE AT LOW TEMPERATURE", 1 janvier 2006 (2006-01-01), MACROMOLECULES, AMERICAN CHEMICAL SOCIETY, WASHINGTON, DC; US, PAGE(S) 8274 - 8282, XP002508144, ISSN: 0024-9297 [extrait le 2006-10-25] experimental part

## Description

L'invention concerne un nouveau procédé de préparation de surface utilisant des polymères comprenant au moins une liaison carbone -oxygène telle que l'on trouve dans les alcoxyamines génératrice de radicaux libres lorsque la molécule est activée par voie thermique, oxydo-réduction organique ou inorganique, photochimique, plasma, cisaillement ou encore sous l'influence de rayons ionisants.

L'invention concerne également l'utilisation de ce nouveau procédé de préparation, en particulier dans les applications de contrôle de l'énergie de surface d'un support. Par exemple cela peut permettre de structurer un copolymère à blocs ultérieurement déposé mais l'invention permet également de traiter des surfaces pour améliorer l'aptitude à l'impression d'encres ou de peinture, la mouillabilité, la résistance aux intempéries ou au vieillissement, l'adhésion, la biocompatibilité, la prévention de la migration des encres, la prévention des dépôts de protéines, de salissures ou des moisissures.

En raison de leur capacité à se nanostructurer, l'utilisation des copolymères à blocs dans les domaines de l'électronique ou de l'optoélectronique est maintenant bien connue.
Il est en particulier possible de structurer l'arrangement des blocs constituant les copolymères à des échelles inférieures à 50 nm.

La structuration recherchée (par exemple, génération des domaines perpendiculaires à la surface) nécessite cependant la préparation du support sur lequel le copolymère à blocs est déposé en vue de contrôler l'énergie de surface. Parmi les possibilités connues, on dépose sur le support un copolymère statistique dont les monomères peuvent être identiques en tout ou partie à ceux utilisés dans le copolymère à blocs que l'on veut déposer.

En outre, si l'on souhaite éviter par exemple la diffusion du copolymère statistique, il est préférable de greffer et/ou de réticuler le copolymère sur la surface, par l'utilisation de fonctionnalité adéquate. On entend par greffage la formation d'une liaison par exemple covalente entre le support et le copolymère. Par réticulation on entend la présence de plusieurs liaisons entre les chaînes copolymères.

### Art antérieur :

Parmi les différentes possibilités utilisées pour orienter la morphologie d'un copolymère à blocs sur une surface, on dépose préalablement sur la surface une couche d'un copolymère statistique PMMA/PS.
Mansky et al. dans Science, vol 275 pages 1458-1460 (7 mars 1997) ont montré qu'un copolymère statistique Poly (méthacrylate de méthyle co styrène) (PMMA/PS) fonctionnalisé par une fonction hydroxy en bout de chaîne permet un bon greffage du copolymère à la surface. Les auteurs attribuent la faculté de greffage de ces copolymères à la présence du groupement terminal hydroxy provenant de l'amorceur, ce qui constitue un mécanisme de greffage par condensation peu performant de part la température et les temps nécessaires, typiquement 24 à 48 h, à 140°C dans cette publication.

A une certaine fraction molaire des monomères méthacrylate de méthyle et styrène (MMA et STY), les énergies d'interface d'un copolymère statistique avec le PS et respectivement le PMMA sont rigoureusement les mêmes (Mansky et al., Macromolecules 1997, 30, 6810-6813). Cette situation se présente dans le cas d'un support silicium présentant une fine couche d'oxyde à la surface. Dans ce cas, cela peut présenter un inconvénient car la composition idéale du copolymère statistique doit exactement présenter cette fraction pour que les énergies des interfaces avec le PS et avec le PMMA soient les mêmes. Lorsque la composition du copolymère statistique change, les auteurs ont montré qu'un copolymère diblocs PS-PMMA déposé sur le copolymère statistique peut présenter des morphologies qui dépendent de la composition du copolymère statistique. On peut donc changer la morphologie du copolymère diblocs en cas de dérive de la fraction MMA/STY du copolymère statistique.

Plus récemment certains auteurs (Han et al ., Macromolecules, 2008, 9090-9097, Ji et al Macromolecules, 2008, 9098-9103, Insik In et al., Langmuir 2006, 22, 7855-7860)ont montré qu'on pouvait avantageusement améliorer le greffage du copolymère statistique sur la surface en introduisant, non plus en bout de chaîne, mais au sein même du copolymère statistique plusieurs fonctionnalités telles que hydroxy ou époxy. Dans ce cas le copolymère est greffé par plusieurs fonctions sur la surface (cas des hydroxy)et en plus réticulé à la surface (cas des epoxy).
Dans la demande US 20090186234, on considère la réticulation du copolymère statistique. Cette approche est également reportée dans de nombreux articles, parmi lesquels ceux de Ryu et al., Macromolecules, 2007, 40, 4296-4300 ; Bang J. et al., Adv. Mat., 2009, 21, 1-24, ou encore US 20090179001. Avec l'utilisation de copolymères statistiques réticulables tels que largement utilisés dans les approches les plus récentes, une limitation apparait lorsque l'on souhaite neutraliser une surface de topographie donnée. Le dépôt du copolymère statistique suivi de sa réticulation vient complètement couvrir la surface de topographie donnée qui ne peut plus être exploitée en tant que telle, la réticulation empêchant toute élimination d'une partie de la surface non souhaitée couverte, rendant cette surface dite non conforme. Lorsque l'on utilise les copolymères non réticulés il est possible d'enlever le copolymère statistique distant de la surface car non greffé, par exemple par lavage de la surface avec un solvant adéquat. Ainsi après élimination de cet excès de copolymère, on retrouve la topographie de la surface initiale, dite dans ce cas conforme.
Si les approches préalablement décrites dans la littérature autorisent certains contrôles de l'orientation d'un copolymère à blocs sur une surface traitée par un copolymère statistique, il apparaît une limitation sur l'étendue de la surface considérée. Ceci limite les applications industrielles afin d'obtenir des grandes surfaces de copolymères à blocs organisés permettant notamment l'obtention de matériaux pour l'électronique à des coûts compétitifs.
Par ailleurs, ces approches nécessitent des temps ou des températures nécessaires au greffage et/ou à la réticulation des copolymères statistiques souvent prohibitifs à l'échelle industrielle.

En outre, les surfaces traitées par les copolymères statistiques doivent dans l'art antérieur être préalablement préparées selon des protocoles particuliers ce qui complique les processus d'application.

La demanderesse a maintenant découvert que les polymères fonctionnalisés ou non, comprenant au moins une liaison carbone -oxygène telle que l'on trouve dans les alcoxyamines pouvant générer des radicaux libres peuvent avantageusement se substituer aux copolymères utilisés dans l'art antérieur, qu'ils soient réticulables ou non, en présentant de nombreux avantages tels que des temps de greffage ou de réticulation très rapides, une régularité de dispersion à la surface du support permettant le dépôt ultérieur de copolymères à blocs dont la morphologie est contrôlée et régulière sur de grandes surfaces, et évitant les traitements fastidieux du support avant d'y être déposés avec un bon greffage sur de nombreuses surfaces de différentes origines chimiques. La demanderesse a également observé un excellent contrôle de la taille des domaines à des échelles pouvant être largement inférieures à 20 nm. Enfin les polymères de l'invention comprenant au moins une liaison carbone -oxygène telle que l'on trouve dans les alcoxyamines autorisent une excellente préparation des surfaces présentant une topographie qui peuvent ultérieurement faire l'objet d'un dépôt d'un copolymère à blocs selon une orientation donnée, tout en conservant la topographie du support initial.

### Résumé de l'invention :

La présente invention concerne un procédé de préparation de surface utilisant des polymères comprenant au moins une liaison carbone -oxygène telle que l'on trouve dans les alcoxyamines génératrice de radicaux libres lorsque que la molécule est activée par voie thermique, oxydo-réduction organique ou inorganique, photochimique, cisaillement, plasma, ou encore sous l'influence de rayons ionisants, comprenant les étapes suivantes :
- mise en contact des molécules avec la surface à traiter
- activation de la liaison covalente génératrice de radicaux libres par voie thermique, oxydo-réduction organique ou inorganique, photochimique, cisaillement, plasma, ou encore sous l'influence de rayons ionisants pour former un film d'épaisseur inférieur à 10 nm et de préférence 5 nm sur la surface.
- évaporation du solvant de solubilisation ou de dispersion ayant servi pour la mise en contact des molécules avec la surface à traiter lorsqu'il est présent.

### Description détaillée.

Les homopolymères ou copolymères utilisés dans le procédé de l'invention peuvent être obtenus par n'importe quelle voie parmi lesquelles on peut citer la polycondensation, la polymérisation par ouverture de cycle, la polymérisation anionique, cationique ou radicalaire cette dernière pouvant être contrôlée ou non. Lorsque les copolymères sont préparés par polymérisation ou télomérisation radicalaire, celle-ci peut être contrôlée par toute technique connue telle que NMP ("Nitroxide Mediated Polymerization"), RAFT ("Reversible Addition and Fragmentation Transfer"), ATRP ("Atom Transfer Radical Polymerization"),INIFERTER ("Initiator-Transfer-Termination"), RITP (" Reverse Iodine Transfer Polymerization"), ITP ("Iodine Transfer Polymerization).

On privilégiera les procédés de polymérisation ne faisant pas intervenir de métaux. De préférence les copolymères sont préparés par polymérisation radicalaire, et plus particulièrement par polymérisation radicalaire contrôlée, encore plus particulièrement par polymérisation contrôlée par les nitroxydes.

Les polymères utilisées dans le procédé de l'invention répondent à la formule générale suivante :

R1 A R2

A est une liaison covalente génératrice de radicaux libres dont l'énergie de liaison est comprise entre 90 et 270 KJ/mole et de préférence entre 100 et 170 KJ/mole, à 25°C mesuré selon la méthode décrite selon Kerr, Chem. Rev. 66, 465-500 (1966).

De préférence il s'agit d'une liaison carbone-oxygène telle que l'on trouve dans les alcoxyamines.
Plus particulièrement, les alcoxyamines dérivées du radical libre stable (1) sont préférées. 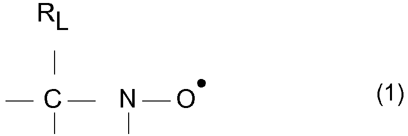 Dans laquelle le radical R_{L} présente une masse molaire supérieure à 15,0342 g/mole. Le radical R_{L} peut être un atome d'halogène tel que le chlore, le brome ou l'iode, un groupement hydrocarboné linéaire, ramifié ou cyclique, saturé ou insaturé tel qu'un radical alkyle ou phényle, ou un groupement ester -COOR ou un groupement alcoxyle -OR, ou un groupement phosphonate -PO(OR)₂, dès lors qu'il présente une masse molaire supérieure à 15,0342. Le radical R_{L}, monovalent, est dit en position β par rapport à l'atome d'azote du radical nitroxyde. Les valences restantes de l'atome de carbone et de l'atome d'azote dans la formule (1) peuvent être liées à des radicaux divers tels qu'un atome d'hydrogène, un radical hydrocarboné comme un radical alkyle, aryle ou aryle-alkyle, comprenant de 1 à 10 atomes de carbone. Il n'est pas exclu que l'atome de carbone et l'atome d'azote dans la formule (1) soient reliés entre eux par l'intermédiaire d'un radical bivalent, de façon à former un cycle. De préférence cependant, les valences restantes de l'atome de carbone et de l'atome d'azote de la formule (1) sont liées à des radicaux monovalents. De préférence, le radical R_{L} présente une masse molaire supérieure à 30 g/mole. Le radical R_{L} peut par exemple avoir une masse molaire comprise entre 40 et 450 g/mole. A titre d'exemple, le radical R_{L} peut être un radical comprenant un groupement phosphoryle, ledit radical R_{L} pouvant être représenté par la formule : 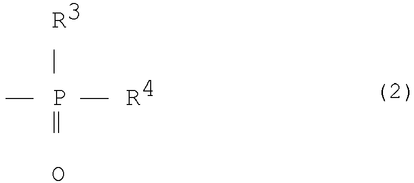 dans laquelle R³ et R⁴, pouvant être identiques ou différents, peuvent être choisis parmi les radicaux alkyle, cycloalkyle, alkoxyle, aryloxyle, aryle, aralkyloxyle, perfluoroalkyle, aralkyle, et peuvent comprendre de 1 à 20 atomes de carbone. R³ et/ou R⁴ peuvent également être un atome d'halogène comme un atome de chlore ou de brome ou de fluor ou d'iode. Le radical R_{L} peut également comprendre au moins un cycle aromatique comme pour le radical phényle ou le radical naphtyle, ce dernier pouvant être substitué, par exemple par un radical alkyle comprenant de 1 à 4 atomes de carbone.

Plus particulièrement les alcoxyamines dérivées des radicaux stables suivants sont préférées :
- N-tertiobutyl-1-phényl-2 méthyl propyl nitroxyde,
- N-tertiobutyl-1-(2-naphtyl)-2-méthyl propyl nitroxyde,
- N-tertiobutyl-1-diéthylphosphono-2,2-diméthyl propyl nitroxyde,
- N-tertiobutyl-1-dibenzylphosphono-2,2-diméthyl propyl nitroxyde,
- N-phényl-1-diéthyl phosphono-2,2-diméthyl propyl nitroxyde,
- N-phényl-1-diéthyl phosphono-1-méthyl éthyl nitroxyde,
- N-(1-phényl 2-méthyl propyl)-1-diéthylphosphono-1-méthyl éthyl nitroxyde,
- 4-oxo-2,2,6,6-tétraméthyl-1-piperidinyloxy,
- 2,4,6-tri-tert-butylphenoxy.

Outre leur énergie de liaison, les alkoxyamines utilisées en polymérisation radicalaire contrôlée doivent permettre un bon contrôle de l'enchaînement des monomères. Ainsi elles ne permettent pas toutes un bon contrôle de certains monomères. Par exemples les alcoxyamines dérivées du TEMPO ne permettent de contrôler qu'un nombre limité de monomères, il en va de même pour les alcoxyamines dérivées du 2,2,5-tri-methyl-4-phenyl-3-azahexane-3-nitroxyde (TIPNO). En revanche d'autres alcoxyamines dérivées des nitroxydes répondant à la formule (1), particulièrement celles dérivées des nitroxydes répondant à la formule (2) et encore plus particulièrement celles dérivées du N-tertiobutyl-1-diéthylphosphono-2,2-diméthyl propyl nitroxyde permettent d'élargir à un grand nombre de monomère la polymérisation radicalaire contrôlée de ces monomères.

En outre la température d'ouverture des alcoxyamines influe également sur le facteur économique. L'utilisation de basses températures sera préférée pour minimiser les difficultés industrielles. On préfèrera donc les alkoxyamines dérivées des nitroxydes répondant à la formule (1), particulièrement celles dérivées des nitroxydes répondant à la formule (2) et encore plus particulièrement celles dérivées du N-tertiobutyl-1-diéthylphosphono-2,2-diméthyl propyl nitroxyde à celles dérivées du TEMPO ou 2,2,5-tri-methyl-4-phenyl-3-azahexane-3-nitroxyde (TIPNO).

### R1 et R2 sont au moins deux atomes distincts ou non.

De préférence R1 et R2 peuvent être de petites molécules, ou des macromolécules. Lorsque qu'il s'agit de macromolécules, R1 et R2 peuvent être un oligomère ou un polymère. Plus préférentiellement, il s'agit pour R1 d'homopolymères, de copolymères statistiques ou à blocs, à gradient, à peigne, de masse moléculaire mesurée par SEC supérieure à 500 g/mole et pour R2 d'un groupement moléculaire de masse < 1000g/mole.

On entend par copolymère à gradient un copolymère d'au moins deux monomères obtenu généralement par polymérisation vivante ou pseudo vivante. Grâce à ces modes de polymérisation, les chaînes polymères croissent simultanément et donc incorporent à chaque instant les mêmes ratio de co-monomères. La distribution dans les chaînes polymères des co-monomères dépend donc de l'évolution, pendant la synthèse, des concentrations relatives des co-monomères. On se rapportera aux publications suivantes pour une description théorique des copolymères à gradient :T. Pakula & al., Macromol. Theory Simul. 5, 987-1006 (1996) ; A. Aksimetiev & al. J. of Chem. Physics 111, n°5 ; M. Janco J. Polym. Sci., Part A: Polym. Chem. (2000), 38(15), 2767-2778 ; M. Zaremski, & al Macromolecules (2000), 33(12), 4365-4372 ; K. Matyjaszewski & al. J. Phys. Org. Chem. (2000), 13(12), 775-786 ; Gray Polym. Prepr. (Am. Chem. Soc., Div. Polym. Chem.) (2001), 42(2), 337-338 ; K. Matyjaszewski Chem. Rev. (Washington, D. C.) (2001), 101(9), 2921-2990.

Concernant les monomères qui peuvent être utilisés pour R1, on peut citer:
Pour les précurseurs de polymères et copolymères par polycondensation : les monomères utilisés pour la préparation des polyamides ou copolyamides, polyesters ou copolyesters, polyesteramides ou copolyestersamides, polyethers, polyimides, polycétones, polyethers cetones, seuls ou en mélange.
Pour les précurseurs de polymères et copolymères par polymérisation anionique ou cationique ou par ouverture de cycle : les monomères vinylique, vinyle aromatique, vinylidénique, diénique, oléfinique, allylique ou (méth)acrylique, les lactones, carbonates, lactames, lactides ou glycolides, les oxazolines, les époxydes, les cyclosiloxanes, , seuls ou en mélange.

Pour les précurseurs de polymères et copolymères par polymérisation radicalaire :
Au moins un monomère vinylique, vinylidénique, diénique, oléfinique, allylique ou (méth)acrylique. Ce monomère est choisi plus particulièrement parmi les monomères vinylaromatiques tels que le styrène ou les styrènes substitués notamment l'alpha-méthylstyrène, les monomères acryliques tels que l'acide acrylique ou ses sels, les acrylates d'alkyle, de cycloalkyle ou d'aryle tels que l'acrylate de méthyle, d'éthyle, de butyle, d'éthylhexyle ou de phényle, les acrylates d'hydroxyalkyle tels que l'acrylate de 2-hydroxyéthyle, les acrylates d'étheralkyle tels que l'acrylate de 2-méthoxyéthyle, les acrylates d'alcoxy- ou aryloxy-polyalkylèneglycol tels que les acrylates de méthoxypolyéthylèneglycol, les acrylates d'éthoxypolyéthylèneglycol, les acrylates de méthoxypolypropylèneglycol, les acrylates de méthoxypolyéthylèneglycol-polypropylèneglycol ou leurs mélanges, les acrylates d'aminoalkyle tels que l'acrylate de 2-(diméthylamino)éthyle (ADAME), les acrylates fluorés, les acrylates silylés, les acrylates phosphorés tels que les acrylates de phosphate d'alkylèneglycol,les acrylates de glycidyle, de dicyclopentenyloxyethyle, les monomères méthacryliques comme l'acide méthacrylique ou ses sels, les méthacrylates d'alkyle, de cycloalkyle, d'alcényle ou d'aryle tels que le méthacrylate de méthyle (MAM), de lauryle, de cyclohexyle, d'allyle, de phényle ou de naphtyle, les méthacrylates d'hydroxyalkyle tels que le méthacrylate de 2-hydroxyéthyle ou le méthacrylate de 2-hydroxypropyle, les méthacrylates d'étheralkyle tels que le méthacrylate de 2-éthoxyéthyle, les méthacrylates d'alcoxy- ou aryloxy-polyalkylèneglycol tels que les méthacrylates de méthoxypolyéthylèneglycol, les méthacrylates d'éthoxypolyéthylèneglycol, les méthacrylates de méthoxypolypropylèneglycol, les méthacrylates de méthoxypolyéthylèneglycol-polypropylèneglycol ou leurs mélanges, les méthacrylates d'aminoalkyle tels que le méthacrylate de 2-(diméthylamino)éthyle (MADAME), les méthacrylates fluorés tels que le méthacrylate de 2,2,2-trifluoroéthyle, les méthacrylates silylés tels que le 3-méthacryloylpropyltriméthylsilane, les méthacrylates phosphorés tels que les méthacrylates de phosphate d'alkylèneglycol, le méthacrylate d'hydroxy-éthylimidazolidone, le méthacrylate d'hydroxy-éthylimidazolidinone, le méthacrylate de 2-(2-oxo-1-imidazolidinyl)éthyle, l'acrylonitrile, l'acrylamide ou les acrylamides substitués, la 4-acryloylmorpholine, le N-méthylolacrylamide, le méthacrylamide ou les méthacrylamides substitués, le N-méthylolméthacrylamide, le chlorure de méthacrylamido-propyltriméthyle ammonium (MAPTAC), les méthacrylates de glycidyle, de dicyclopentenyloxyethyle, l'acide itaconique, l'acide maléique ou ses sels, l'anhydride maléique, les maléates ou hémimaléates d'alkyle ou d'alcoxy- ou aryloxy-polyalkylèneglycol, la vinylpyridine, la vinylpyrrolidinone, les (alcoxy) poly(alkylène glycol) vinyl éther ou divinyl éther, tels que le méthoxy poly(éthylène glycol) vinyl éther, le poly(éthylène glycol) divinyl éther, les monomères oléfiniques, parmi lesquels on peut citer l'éthylène, le butène, l'hexène et le 1-octène, les monomères dièniques dont le butadiène, l'isoprène ainsi que les monomères oléfiniques fluorés, et les monomères vinylidénique, parmi lesquels on peut citer le fluorure de vinylidène, seuls ou en mélange d'au moins deux monomères précités.

R1 est un radical polymère, copolymère, oligomère ou co-oligomère et R2 un groupement nitroxy.

De façon préférée, R2 est le N-tertiobutyl-1-diéthylphosphono-2,2-diméthyl propyl nitroxyde.

De préférence R1 est un copolymère statistique dont la masse moléculaire mesurée par SEC avec des étalons polystyrène est comprise entre 500 g et 200000 g/mole, plus préférentiellement comprise entre 1000 et 20000 g/mole, et encore plus préférentiellement comprise entre 5000 et 10000 g/mole ceci pour obtenir un dépôt de copolymère selon le procédé de l'invention inférieur à 10 nm et plus particulièrement inférieur à 5 nm. La dispersité de R1, rapport des masses moléculaires moyennes en poids au masses moléculaires moyennes en nombre est inférieure à 5 , plus particulièrement inférieure à 2, et de façon préférée inférieure à 1,5.
De préférence R1 est constitué des monomères parmi lesquels on peut citer le styrène, le méthacrylate de méthyle, Le méthacrylate de glycidyle (GMA), le méthacrylate de 2-hydroxy éthyle (HEMA), l'acrylate de méthyle ou d'éthyle. Le styrène est présent de préférence dans le copolymère dans des quantités molaires allant de 40 à 100 % et encore plus préférentiellement de 60 à 85 %.
Selon une forme préférée de l'invention, le copolymère statistique de l'invention est préparé avec l'acide 2-méthyl-2-[N-tertiobutyl-N-(diéthoxyphosphoryl 2,2diméthylpropyl) aminoxy] propionique (Blocbuilder MA® - Arkema), le styrène et le méthacrylate de méthyle.

Concernant le procédé de préparation de surface utilisant les polymères de l'invention, il est applicable sur toute surface, et ne nécessite pas de préparation particulière comme cela est souvent le cas lorsque l'on veut préparer une surface pour y déposer un copolymère statistique en vue d'un dépôt ultérieur de copolymère à bloc présentant une morphologie régulière sur une grande surface, sans défauts. De préférence la surface est minérale et plus préférentiellement du silicium. De manière encore plus préférentielle, la surface est du silicium présentant une couche d'oxyde natif.

Selon une forme préférée de l'invention, les copolymères à blocs déposés sur les surfaces traitées par le procédé de l'invention sont de préférence des copolymères diblocs.

Le procédé de l'invention consiste à déposer de préférence les polymères préalablement dissouts dans un solvant adéquat selon des techniques connues de l'homme de métier comme par exemple la technique dite « spin coating », « docteur Blade » « knife system », « slot die system » mais tout autre technique peut être utilisée telle qu'un dépôt à sec, c'est-à-dire sans passer par une dissolution préalable.
Le procédé de l'invention visera à former une couche de polymère typiquement inférieure à 10nm et de préférence inférieure à 5 nm. Lorsque le procédé de l'invention est utilisé pour préparer des surfaces en vue d'un dépôt de copolymère à blocs, le polymère sera de préférence un copolymère statistique et les énergies d'interaction avec les deux blocs du ou des copolymères à blocs ultérieurement déposé seront équivalentes.

Le procédé de l'invention peut être utilisé dans les applications nécessitant un contrôle de l'énergie de surface telles le dépôt de copolymères à blocs présentant une nanostructuration donnée, l'amélioration de l'aptitude à l'impression d'encres ou de peinture, de la mouillabilité, de la résistance aux intempéries ou au vieillissement, de l'adhésion, de la biocompatibilité, de la prévention de la migration des encres, de la prévention des dépôt de protéines, de salissures ou des moisissures.

Exemple 1 : préparation d'une alcoxyamine fonctionnalisée hydroxy (amorceur 2) à partir de l'alcoxyamine commerciale BlocBuilder®MA (amorceur 1) :
Dans un ballon de 1L purgé à l'azote, on introduit :
- 226,17 g de BlocBuilder®MA (amorceur 1) (1 équivalent)
- 68,9 g d'acrylate de 2-hydroxyethyle (1 équivalent)
- 548 g d'isopropanol
Le mélange réactionnel est chauffé à reflux (80°C) pendant 4h puis l'isopropanol est évaporé sous vide. On obtient 297 g d' alcoxyamine fonctionnalisée hydroxy (amorceur 2) sous la forme d'une huile jaune très visqueuse.

### Exemple 2 :

Protocole expérimental de préparation de copolymères à partir des amorceurs 1, 2, 3 ou 4.
- l'amorceur 1 est l'alcoxyamine commerciale BlocBuilder®MA.
- l'amorceur 2 est l'alcoxyamine préparée selon l'exemple 1.
- l'amorceur 3 est constitué d'un couple de réactifs :
   l'azoisobutyronitrile (AIBN) (1 équivalent molaire) et le nitroxyde de N-tert-butyl-1-diéthyl phosphono-2,2-diméthyl propyle (2 équivalents molaire).
- l'amorceur 4 est l'azoisobutyronitrile (AIBN).

### • Préparation de copolymères Polystyrène / Polyméthacrylate de méthyle, Polystyrène/Polyméthacrylate de méthyle/Polyméthacrylate de 2-hydroxyéthyle ou Polystyrène/Polyméthacrylate de méthyle /Polyméthacrylate de glycidyle

Dans un réacteur en acier inoxydable équipé d'un agitateur mécanique et d'une double enveloppe, sont introduits le toluène, ainsi que les monomères tels que le styrène (S), le méthacrylate de méthyle (MMA), le méthacrylate de 2-hydroxyéthyle (HEMA), le méthacrylate de glycidyle (GMA) et l'amorceur. Les ratios massiques entre les différents monomères styrène (S), le méthacrylate de méthyle (MMA), le méthacrylate de 2-hydroxyéthyle (HEMA) et le méthacrylate de glycidyle (GMA) sont décrits dans le tableau 1. La charge massique de toluène est fixée à 30% par rapport au milieu réactionnel. Le mélange réactionnel est agité et dégazé par un bullage d'azote à température ambiante pendant 30 minutes.

La température du milieu réactionnel est alors portée à 115°C (dans le cas des polymérisations réalisées en présence d'amorceurs 1, 2 et 3) ou 75°C (dans le cas des polymérisations réalisées en présence d'amorceur 4). Le temps t=0 est déclenché à température ambiante. La température est maintenu à 115 ou 75°C tout le long de la polymérisation jusqu'à atteindre une conversion des monomères de l'ordre de 70%. Des prélèvements sont réalisés à intervalles réguliers afin de déterminer la cinétique de polymérisation par gravimétrie (mesure d'extrait sec). Lorsque la conversion de 70% est atteinte, le milieu réactionnel est refroidi à 60°C et le solvant et monomères résiduels sont évaporés sous vide. Après évaporation, la méthyléthylcétone est additionnée au milieu réactionnel en quantité telle que l'on réalise une solution de copolymère de l'ordre de 25% massique.

Cette solution de copolymère est alors introduite goutte à goutte dans un bécher contenant un non-solvant (l'heptane), de manière à faire précipiter le copolymère. Le ratio massique entre solvant et non-solvant (méthyléthylcétone/heptane) est de l'ordre de 1/10. Le copolymère précipité est récupéré sous la forme d'une poudre blanche après filtration et séchage.

**Tableau 1**

| | **Etat initial de réaction** | | | **Caractéristiques du copolymère** | | | | | |
|---|---|---|---|---|---|---|---|---|---|
| **Copolymères** | **Composition massique initiale des monomères S/MMA/HEMA/GMA** | **Nature de l'amorceur utilisé** | **Ratio massique d'amorceur par rapport aux monomères S, MMA, HEMA et GMA** | **%PS^{(a)}** | **Mp^{(a)}** | **Mn^{(a)}** | **Mw^{(a)}** | **Ip^{(a)}** | |
| **1** | 42/58/0/0 | amorceur 2 | 0,03 | 48% | 18 760 | 12 980 | 18 940 | 1,5 | invention |
| **2** | 50/50/0/0 | amorceur 2 | 0,04 | 69% | 18 930 | 12410 | 20 360 | 1,6 | invention |
| **3** | 58/42/0/0 | amorceur 2 | 0,03 | 64% | 16 440 | 11 870 | 16 670 | 1,4 | invention |
| **4** | 66/34/0/0 | amorceur 2 | 0,03 | 65% | 15 480 | 11 930 | 15 900 | 1,3 | invention |
| **5** | 74/26/0/0 | amorceur 2 | 0,03 | 70% | 15 210 | 12 060 | 15 760 | 1,3 | invention |
| **6** | 58/34/4/0 | amorceur 2 | 0,03 | 57% | 17 730 | 12 870 | 18 210 | 1,4 | invention |
| **8** | 58/42/0/0 | amorceur 2 | 0,02 | 60% | 49 020 | 23 150 | 46 280 | 2,0 | invention |
| **9** | 58/42/0/0 | amorceur 2 | 0,01 | 59% | 90 010 | 36 350 | 80 270 | 2,2 | invention |
| **10** | 58/38/4/0 | amorceur 1 | 0,03 | 58% | 14 530 | 10410 | 14 560 | 1,4 | invention |
| **11** | 74/26/0/0 | amorceur 1 | 0,03 | 73% | 15 040 | 12 280 | 15 400 | 1,2 | invention |
| **12** | 85/15/0/0 | amorceur 2 | 0,03 | 84% | 16 170 | 13 660 | 17 310 | 1,3 | invention |
| **14** | 74/23,5/0/2,5 | amorceur 2 | 0,03 | 73% | 17 690 | 14 620 | 26 490 | 1,8 | invention |
| **16** | 74/26/0/0 | amorceur 2 | 0,07 | 73% | 8 380 | 7 120 | 8 960 | 1,3 | invention |
| **17** | 74/26/0/0 | amorceur 3 | 0,03 | 72% | 17 260 | 12 700 | 17 400 | 1,4 | invention |
| **18** | 100/0/0/0 | amorceur 2 | 0,07 | 100% | 7 440 | 6 710 | 8 080 | 1,2 | invention |
| **19** | 49/51/0/0 | amorceur 4 | 0,02 | 46% | 39 500 | 23 000 | 40 000 | 1,7 | hors invention |
| **20** | 74/26/0/0 | amorceur 4 | 0,02 | 64% | 39 000 | 25 000 | 39 600 | 1,6 | hors invention |
| **21** | 100/00/0 | amorceur 1 | 0,03 | 100% | 13 270 | 11 390 | 13 740 | 1,2 | invention |

(a) Déterminées par chromatographie d'exclusion stérique. Les polymères sont solubilisés à 1g/l dans du THF stabilisé au BHT. L'étalonnage est effectué grâce à des étalons de polystyrène monodisperses. La double détection par indice de réfraction et UV à 254nm permet de déterminer le pourcentage de polystyrène dans le copolymère.

### Exemple 3 :

Outre les copolymères décrits dans l'exemple 2 Le copolymère à bloc PS-b-PMMA (PS 46.1 kg.mol⁻¹, PMMA 21 kg.mol⁻¹, PDI = 1.09) a été acheté chez Polymer Source Inc. (Dorval, Québec) et utilisé sans purification ultérieure.

### Greffage sur SiO₂ :

Les plaques de silicium (orientation cristallographique {100}) sont découpées manuellement en pièces de 3x4 cm et nettoyées par traitement piranha (H₂SO₄/H₂O₂ 2:1 (*v:v*)) durant 15 minutes, puis rincées à l'eau dé-ionisée, et séchées sous flux d'azote juste avant fonctionnalisation. La suite de la procédure est celle décrite par Mansky &al. (Science, 1997, 1458), avec une seule modification (le recuit se fait sous atmosphère ambiante et non pas sous vide). Les copolymères statistiques sont dissous dans du toluène afin d'obtenir des solutions à 1.5% en masse. Une solution de PS-r-PMMA est dispensée à la main sur un wafer fraîchement nettoyé, puis étalée par spin-coating à 700 rpm afin d'obtenir un film d'environ 90nm d'épaisseur. Le substrat est alors simplement déposé sur une plaque chauffante, préalablement portée à la température voulue, sous atmosphère ambiante durant un temps variable. Le substrat est alors lavé par sonication dans plusieurs bains de toluène durant quelques minutes afin d'éliminer le polymère non-greffé de la surface, puis séché sous flux d'azote.

### Greffage sur or :

Les substrats d'or utilisés sont constitués d'or polycristallin, et sont fabriqués comme suit : une couche de silice thermique est tout d'abord déposée sur une surface de Si (100nm), puis une couche d'accroche de chrome (∼10nm) est évaporée sur la surface, et enfin une couche de ∼500nm d'or est évaporée sur le substrat.

Les surfaces d'or sont nettoyées par un plasma d'oxygène durant 5 minutes, puis les oxydes d'or formés sont réduits par un bain dans l'éthanol absolu durant 20 minutes et la surface est séchée sous flux d'azote (H.Ron &al., Langmuir, 1998, 1116). Si on ne souhaite pas utiliser de plasma, les surfaces d'or peuvent être simplement lavées par sonication dans un bain d'éthanol absolu puis un bain de toluène durant 10 minutes, puis séchées sous flux d'azote.

La procédure suivie pour effectuer le greffage des polymères sur or est identique à celle des surfaces de silice.

### Caractérisations :

Les mesures d'XPS ont été effectuées sur un spectromètre personnalisé 220 I de chez VG Scientific ; les spectres ont été obtenus avec une source de rayons X calibrée sur la raie Kα de l'aluminium (1486.6eV). Les mesures d'épaisseur de film ont été effectuées sur un ellipsomètre Prometrix UV1280. Les images obtenues par microscopie électronique à balayage ont été effectuées sur un CD-SEM H9300 de chez Hitachi.

### Exemple 4 :

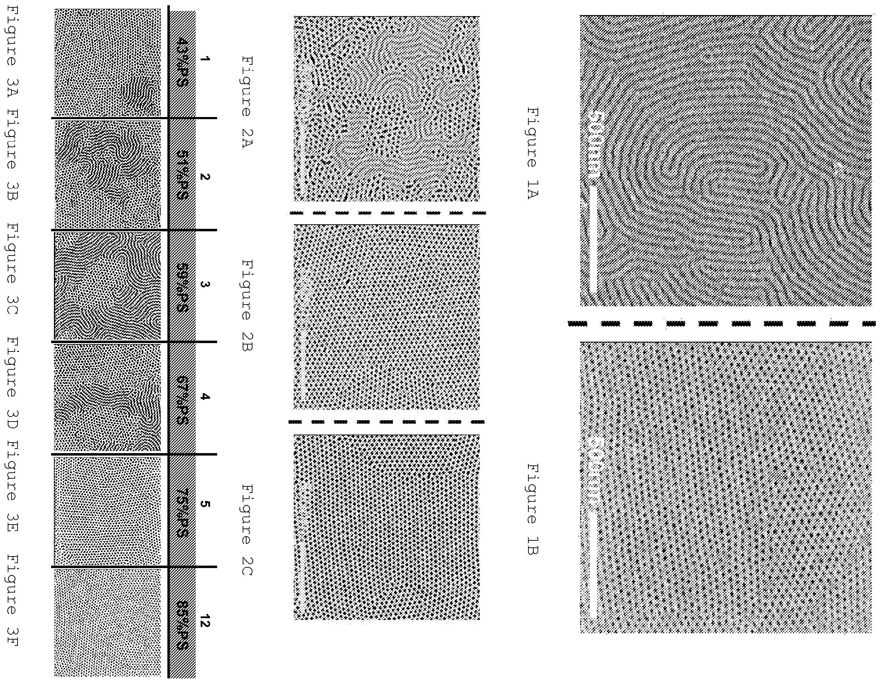

Dans cet exemple on compare la morphologie observée pour l'auto-assemblage du copolymère à blocs cylindrique (PS-b-PMMA) de l'exemple 3 lorsque celui-ci est déposé sur une surface de silicium non traitée (figure 1A) conduisant à une orientation parallèle du copolymère à bloc par rapport à la surface ou sur une surface traitée selon le procédé de l'invention utilisant le copolymère statistique 5 de tu tableau 1 et conduisant à une orientation perpendiculaire du copolymère à bloc par rapport à la surface (figure 1B).

### Exemple 5 :

Dans cet exemple on compare la morphologie observée pour l'autoassemblage du copolymère à blocs cylindrique (PS-b-PMMA) de l'exemple 3 lorsque celui-ci est déposé sur une surface d'or polycristallin nettoyée mais en l'absence de copolymère de l'invention (figure 2A) conduisant à une orientation parallèle et perpendiculaire du copolymère à bloc par rapport à la surface, à une surface d'or polycristallin nettoyée et traitée selon le procédé de l'invention utilisant le copolymère statistique 5 du tableau 1, et conduisant à une orientation perpendiculaire du copolymère à bloc par rapport à la surface (figure 2B), ou à une surface d'or polycristallin non nettoyée et traitée selon le procédé de l'invention utilisant le copolymère statistique 5 du tableau 1, et conduisant à une orientation perpendiculaire du copolymère à bloc par rapport à la surface (figure 2C).

### Exemple 6 :

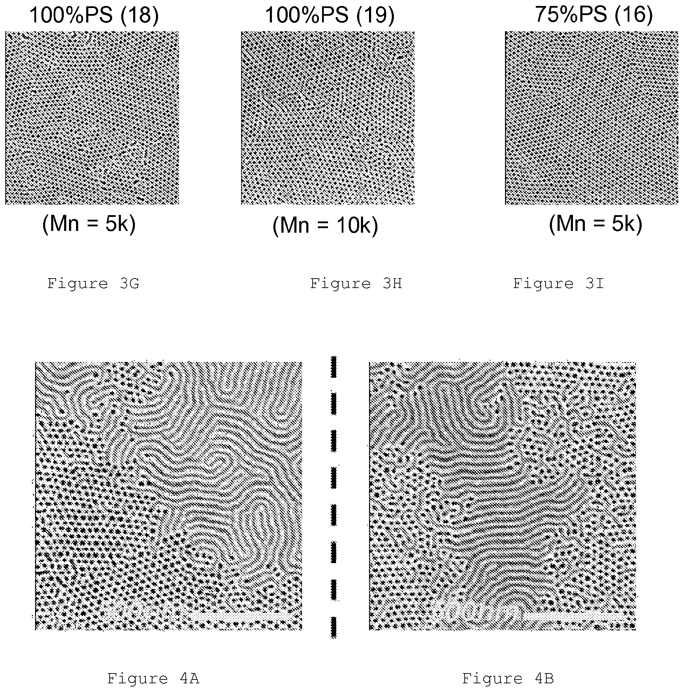

Dans cet exemple on compare la morphologie observée pour l'autoassemblage du copolymère à blocs cylindrique (PS-b-PMMA) de l'exemple 3 lorsque celui-ci est déposé sur une surface de silicium traitée selon le procédé de l'invention utilisant les copolymère statistique 1, 2, 3, 4, 5, 12,16, 18, 19 de du tableau 1 (figures 3A, 3B, 3C, 3D, 3E, 3F, 3G, 3H, 3I) pour lesquels la composition en styrène varie. On remarquera qu'un maximum d'orientation perpendiculaire du copolymère à blocs est situé lorsque la composition du copolymère statistique en styrène dans la zone de 75-85 %.

### Exemple 7 :

Dans cet exemple on compare la morphologie observée pour l'auto-assemblage du copolymère à blocs cylindrique (PS-b-PMMA) de l'exemple 3 lorsque celui-ci est déposé sur une surface de silicium traitée selon le procédé de l'invention utilisant les copolymères statistiques 11 et 17 du tableau 1. On y notera en particulier que la présence de fonction acide et alcoxyamine du copolymère 11 de du tableau 1 ou l'absence de toute fonction autre que l'alcoxyamine du copolymère 17 du tableau 1 conduit au même résultat (figures 4A et 4B).

### Exemple 8 :

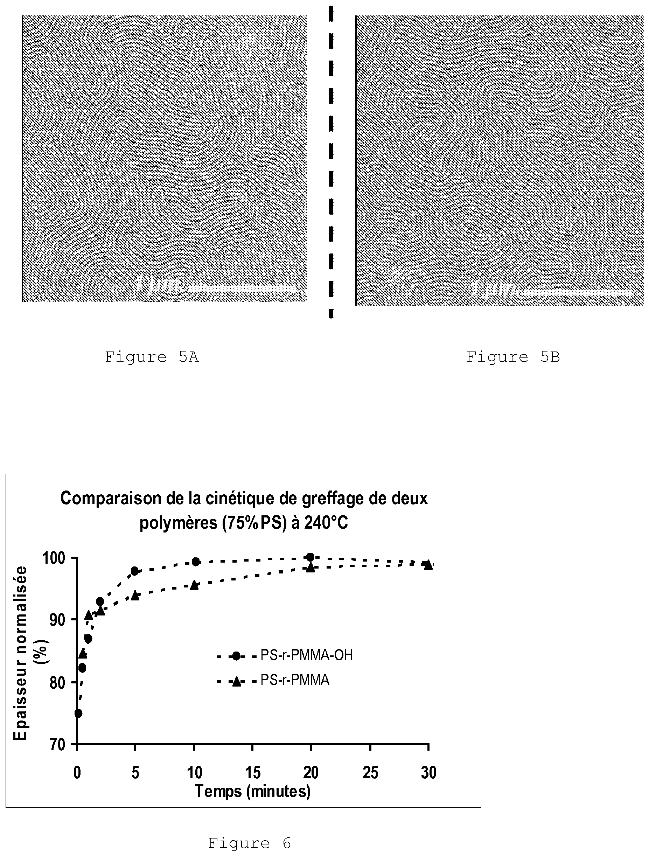

Dans cet exemple on observe la morphologie observée pour l'auto-assemblage du copolymère à blocs cylindrique (PS-b-PMMA) de l'exemple 3 de l'invention lorsque celui-ci est déposé sur une surface de silicium traitée par le copolymère statistique 19 du tableau 1 (figure 5A) ou 20 (figure 5 B) conduisant à une orientation parallèle du copolymère à bloc.

### Exemple 9 :

Dans cet exemple on compare la cinétique de greffage des copolymères 5 et 11 du tableau 1 déposés sur une surface de silicium traitée selon le procédé de l'invention (figure 6, épaisseurs normalisées). Par épaisseur normalisée, on considère que l'épaisseur maximum atteinte par chaque copolymère est de 100%.
On notera que malgré l'absence de fonction hydroxy sur le copolymère 11 (PS-r-PMMA) on observe la même cinétique de greffage que pour le copolymère 5 (PS-PMMA-OH).

### Exemple 10 :

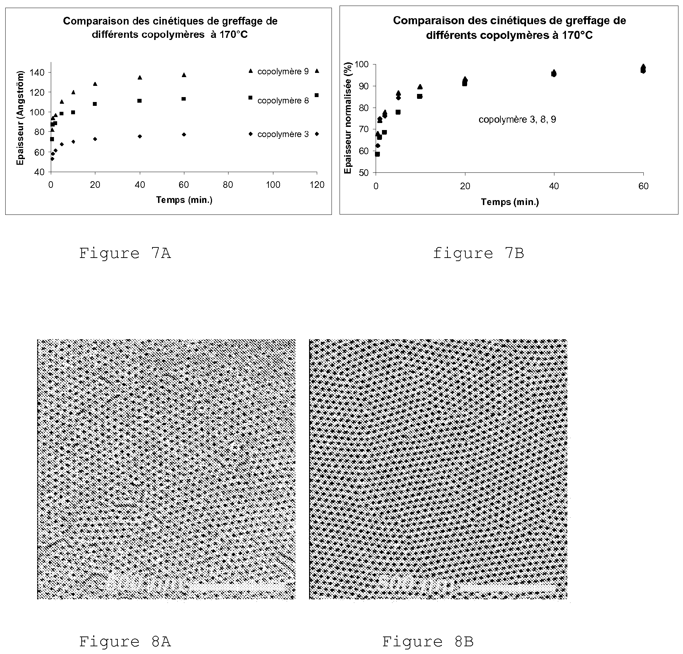

Dans cet exemple on compare la cinétique de greffage des copolymères 3, 8 et 9 du tableau 1 déposés sur une surface de silicium traitée selon le procédé de l'invention. On notera qu'il y a peu d'influence de la masse moléculaire sur la cinétique de greffage (figure 7 A et 7 B).

### Exemple 11 :

Dans cet exemple on observe la morphologie observée pour l'auto-assemblage du copolymère à blocs cylindrique (PS-b-PMMA) lorsque celui-ci est déposé sur une surface de silicium traitée par l'exemple 6 du tableau 1 (figure 8A) et l'exemple 14 du tableau 1 (figure 8B) conduisant à une orientation perpendiculaire du copolymère à bloc.

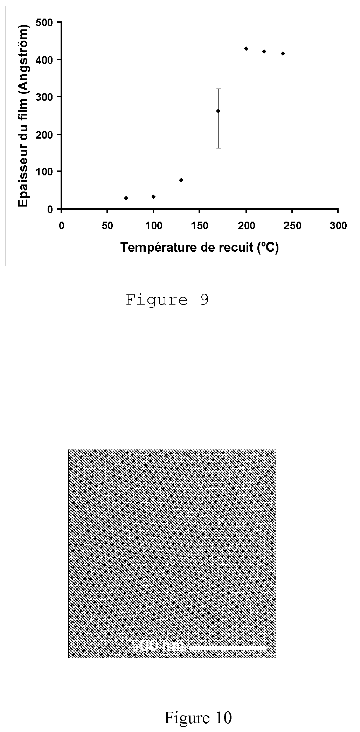

On indique en figure 9 le profil d'épaisseur du film déposé du copolymère 14 en fonction de la température.

### Exemple 12 :

Dans cet exemple on observe la morphologie observée pour l'auto-assemblage du copolymère à blocs cylindrique (PS-b-PMMA) lorsque celui-ci est déposé sur une surface de silicium traitée par l'exemple 21 du tableau 1 (figure 10). Il est à noter que le copolymère de l'exemple 21 du tableau 1 ne comporte pas de fonction hydroxy. La fonction acide présente sur le copolymère de l'exemple 21 ne permet pas ce greffage. Malgré tout la figure 10 montre une orientation perpendiculaire du copolymère à bloc. Le copolymère correspondant à l'exemple 21 du tableau 1 est donc bien greffé sur la surface préalablement au dépôt du copolymère à blocs, et ce par le radical issu de la décomposition de l'alcoxyamine présente en bout de chaine.

## Revendications

1. Procédé de préparation de surface utilisant des polymères comprenant au moins une liaison carbone -oxygène telle que l'on trouve dans les alcoxyamines génératrice de radicaux libres lorsque le polymère est activé par voie thermique, oxydo-réduction organique ou inorganique, photochimique, ou encore sous l'influence de rayons ionisants, comprenant les étapes suivantes :
- mise en contact des polymères avec la surface à traiter.
- activation de la liaison carbone -oxygène telle que l'on trouve dans les alcoxyamines génératrice de radicaux libres par voie thermique, oxydo-réduction organique ou inorganique, photochimique, cisaillement, plasma, ou encore sous l'influence de rayons ionisants pour former un film greffé sur la surface à traiter d'épaisseur inférieur à 10 nm sur la surface.
- évaporation du solvant de solubilisation ou de dispersion ayant servit pour la mise en contact des molécules avec la surface à traiter lorsqu'il est présent.

2. Procédé selon la revendication 1 dans lequel le polymère est un copolymère.

3. Procédé selon la revendication 2 dans lequel le copolymère est un copolymère statistique.

4. Procédé selon la revendication 2 dans lequel le copolymère est un copolymère à gradient.

5. Procédé selon la revendication 2 ou 3 dans lequel le copolymère a une masse moléculaire supérieure à 500g/mole.

6. Procédé selon la revendication 2 ou 3 dans lequel le copolymère a une masse moléculaire comprise entre 1000 et 20000 g/mole.

7. Procédé selon la revendication 2 ou 3 dans lequel le copolymère est préparé par polymérisation radicalaire contrôlée par les nitroxydes.

8. Procédé selon la revendication 7 dans lequel les nitroxydes répondent à la formule suivante : 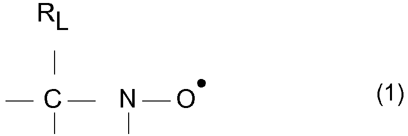 dans laquelle le radical R_{L} présente une masse molaire supérieure à 15,0342.

9. Procédé selon la revendication 8 dans lequel les nitroxydes suivants sont préférés :
- N-tertiobutyl-1-phényl-2 méthyl propyl nitroxyde,
- N-tertiobutyl-1-(2-naphtyl)-2-méthyl propyl nitroxyde,
- N-tertiobutyl-1-diéthylphosphono-2,2-diméthyl propyl nitroxyde,
- N-tertiobutyl-1-dibenzylphosphono-2,2-diméthyl propyl nitroxyde,
- N-phényl-1-diéthyl phosphono-2,2-diméthyl propyl nitroxyde,
- N-phényl-1-diéthyl phosphono-1-méthyl éthyl nitroxyde,
- N-(1-phényl 2-méthyl propyl)-1-diéthylphosphono-1-méthyl éthyl nitroxyde,
- 4-oxo-2,2,6,6-tétraméthyl-1-piperidinyloxy,
- 2,4,6-tri-tert-butylphenoxy.

10. Procédé selon la revendication 9 dans lequel le nitroxyde est le N-tertiobutyl-1-diéthylphosphono-2,2-diméthyl propyl nitroxyde.

11. Procédé selon une des revendications 1 à 10 dans lequel la surface est minérale.

12. Procédé selon une des revendications 1 à 10 dans lequel la surface est métallique.

13. Procédé selon la revendication 11 dans lequel la surface est du silicium.

14. Procédé selon la revendication 12 dans lequel la surface est de l'or.

## Patentansprüche

1. Verfahren zur Oberflächenvorbehandlung unter Verwendung von Polymeren, die mindestens eine Kohlenstoff-Sauerstoff-Bindung enthalten, wie man sie in Alkoxyaminen findet, die freie Radikale erzeugt, wenn man das Polymer thermisch, durch organische oder anorganische Oxidoreduktion, photochemisch oder auch unter dem Einfluss ionisierender Strahlen aktiviert, umfassend die folgenden Schritte:
- Inkontaktbringen der Polymere mit der zu behandelnden Oberfläche,
- Aktivieren der Kohlenstoff-Sauerstoff-Bindung, wie man sie in Alkoxyaminen findet, die freie Radikale erzeugt, thermisch, durch organische oder anorganische Oxidoreduktion, photochemisch, durch Scherung, Plasma oder auch unter Einfluss von ionisierende Strahlen, um einen auf die zu behandelnde Oberfläche gepfropften Film mit einer Dicke von weniger als 10 nm auf der Oberfläche herzustellen,
- Verdampfen des Solubilisierungs- oder Dispersionslösungsmittels, das zum Inkontaktbringen der Moleküle mit der zu behandelnden Oberfläche verwendet wurde, falls vorhanden.

2. Verfahren nach Anspruch 1, wobei das Polymer ein Copolymer ist.

3. Verfahren nach Anspruch 2, wobei das Copolymer ein statistisches Copolymer ist.

4. Verfahren nach Anspruch 2, wobei das Copolymer ein Gradientencopolymer ist.

5. Verfahren nach Anspruch 2 oder 3, wobei das Copolymer eine Molekülmasse von mehr als 500 g/mol besitzt.

6. Verfahren nach Anspruch 2 oder 3, wobei das Copolymer eine Molekülmasse zwischen 1000 und 20000 g/mol besitzt.

7. Verfahren nach Anspruch 2 oder 3, wobei das Copolymer mithilfe von durch Nitroxide kontrollierter radikalischer Polymerisation hergestellt wird.

8. Verfahren nach Anspruch 7, wobei die Nitroxide der folgenden Formel entsprechen: 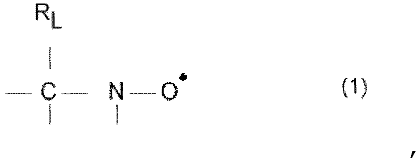 worin der Rest R_{L} eine Molekülmasse von mehr als 15,0342 aufweist.

9. Verfahren nach Anspruch 8, wobei die nachstehenden Nitroxide bevorzugt sind:
- N-tert-Butyl-1-phenyl-2-methylpropylnitroxid,
- N-tert-Butyl-1-(2-naphthyl)-2-methylpropylnitroxid,
- N-tert-Butyl-1-diethylphosphono-2,2-dimethylpropyl-nitroxid,
- N-tert-Butyl-1-dibenzylphosphono-2,2-dimethylpropyl-nitroxid,
- N-Phenyl-1-diethylphosphono-2,2-dimethylpropyl-nitroxid,
- N-Phenyl-1-diethylphosphono-1-methylethyl-nitroxid,
- N-(1-Phenyl-2-methylpropyl)-1-diethylphosphono-1-methylethylnitroxid,
- 4-Oxo-2,2,6,6-tetramethyl-1-piperidinyloxy,
- 2,4,6-Tri-tert-butylphenoxy.

10. Verfahren nach Anspruch 9, wobei es sich bei dem Nitroxid um N-tert-Butyl-1-diethylphosphono-2,2-dimethylpropylnitroxid handelt.

11. Verfahren nach einem der Ansprüche 1 bis 10, wobei die Oberfläche mineralisch ist.

12. Verfahren nach einem der Ansprüche 1 bis 10, wobei die Oberfläche metallisch ist.

13. Verfahren nach Anspruch 11, wobei die Oberfläche aus Silizium besteht.

14. Verfahren nach Anspruch 12, wobei die Oberfläche aus Gold besteht.

## Claims

1. Surface preparation method using polymers comprising at least one carbon-oxygen bond of the kind found in alkoxyamines, which gives rise to free radicals when the polymer is activated thermally, by organic or inorganic reduction-oxidation, photochemically, or else under the influence of ionizing radiation, said method comprising the following steps:
- contacting the polymers with the surface to be treated,
- activating the carbon-oxygen bond of the kind found in alkoxyamines, which gives rise to free radicals thermally, by organic or inorganic reduction-oxidation, photochemically, by shear, by plasma, or else under the influence of ionizing radiation, to form a film grafted onto the surface to be treated having a thickness of less than 10 nm on the surface,
- evaporating, when present, the solubilisation or dispersion solvent employed for contacting the molecules with the surface to be treated.

2. Method according to Claim 1, wherein the polymer is a copolymer.

3. Method according to Claim 2, wherein the copolymer is a random copolymer.

4. Method according to Claim 2, wherein the copolymer is a gradient copolymer.

5. Method according to Claim 2 or 3, wherein the copolymer has a molecular mass of more than 500 g/mol.

6. Method according to Claim 2 or 3, wherein the copolymer has a molecular mass of between 1000 and 20 000 g/mol.

7. Method according to Claim 2 or 3, wherein the copolymer is prepared by nitroxide-controlled radical polymerization.

8. Method according to Claim 7, wherein the nitroxides conform to the formula below: 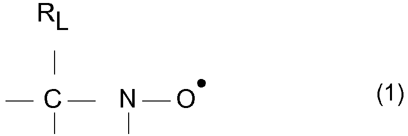 in which the radical R_{L} has a molar mass of more than 15.0342.

9. Method according to Claim 8, wherein the following nitroxides are preferred:
- N-tert-butyl 1-phenyl-2-methylpropyl nitroxide,
- N-tert-butyl 1-(2-naphthyl)-2-methylpropyl nitroxide,
- N-tert-butyl 1-diethylphosphono-2,2-dimethylpropyl nitroxide,
- N-tert-butyl 1-dibenzylphosphono-2,2-dimethylpropyl nitroxide,
- N-phenyl 1-diethylphosphono-2,2-dimethylpropyl nitroxide,
- N-phenyl 1-diethylphosphono-1-methylethyl nitroxide,
- N-(1-phenyl-2-methylpropyl) 1-diethylphosphono-1-methylethyl nitroxide,
- 4-oxo-2,2,6,6-tetramethyl-1-piperidinyloxy,
- 2,4,6-tri-tert-butylphenoxy.

10. Method according to Claim 9, wherein the nitroxide is N-tert-butyl 1-diethylphosphono-2,2-dimethylpropyl nitroxide.

11. Method according to any of Claims 1 to 10, wherein the surface is mineral.

12. Method according to any of Claims 1 to 10, wherein the surface is metallic.

13. Method according to Claim 11, wherein the surface is silicon.

14. Method according to Claim 12, wherein the surface is gold.
